# EUROPÄISCHE PATENTSCHRIFT

(11) **EP 1 152 252 B1**
(45) Veröffentlichungstag und Bekanntmachung des Hinweises auf die Patenterteilung: **11.08.2004**
(21) Anmeldenummer: 01890126.4
(22) Anmeldetag: 03.05.2001
(51) Int. Cl.: G01R 33/07, H01L 43/04

(54) **Verfahren zum Kompensieren von mechanischen Spannungen für die Messung der magnetischen Feldstärke mittels Hallsonden**
Method of compensating mechanical tensions in measuring magnetical field strength with Hall probes
Procédé de compensation de tensions mécaniques pour la mesure de champs magnétiques au moyen de sondes à effet Hall

(30) Priorität: 03.05.2000 AT 3292000 U
(43) Veröffentlichungstag der Anmeldung: 07.11.2001
(73) Patentinhaber: austriamicrosystems AG, 8141 Unterpremstätten (AT)
(72) Erfinder: Kempe, Volker, 8501 Lieboch (AT)
(74) Vertreter: Haffner, Thomas M., Dr.

(56) Entgegenhaltungen:
- EP-A- 0 035 103
- US-A- 5 406 202
- US-A- 5 614 754

## Beschreibung

Die Erfindung betrifft ein Verfahren zum Kompensieren von mechanischen Spannungen für die Messung der magnetischen Feldstärke mittels Hallsonden.

Hallsonden, denen der Halleffekt zugrundeliegt, bestehen üblicherweise aus kleinen Plättchen eines Halbleiters hoher Trägerbeweglichkeit, z.B. InSb. Wenn ein Strom durch diese Plättchen fließt, entsteht senkrecht zu diesem Strom und senkrecht zu einem vorhandenen Magnetfeld eine magnetfeldabhängige Spannung, welche auch Hallspannung bezeichnet wird. Derartige Hallsonden sind für die Messung der magnetischen Feldstärke im Bereich zwischen 10⁻³ und 10⁵ Gauss (1 Gauss = 10⁻⁴ Tesla) geeignet und werden üblicherweise direkt in Silziumhalbleiterscheiben ausgebildet. Häufig werden derartige Hallsonden in Kunststoff oder Keramik gekapselt und sind daher von äußeren Temperatureinflüssen abhängigen mechanischen Spannungen ausgesetzt. Derartige mechanische Spannungen verändern jedoch das Verhalten von Hallsonden und verhindern somit genaue Messungen der magnetischen Feldstärke. Insbesondere wird dadurch die Meßempfindlichkeit von Hallsonden beeinflußt.

Zur Verringerung der Auswirkung von mechanischen Spannungen auf die Empfindlichkeit von Magnetfeldmessungen mittels Hallsonden sind bisher keine geeigneten Maßnahmen vorgeschlagen worden. Die bisherigen Vorschläge zur Verbesserung von Hallsonden-Messungen zielten lediglich darauf ab, die Offset-Spannung von Hallsonden zu kompensieren.

In der US 5 614 754 wird beispielsweise vorgeschlagen eine Hallsonde in der (110) Ebene des Halbleitersubstrates auszubilden und weiters das Verhältnis der Seitenlänge zur Dicke des Halbleitersubstrates 2:1 zu wählen. Dadurch soll die Genauigkeit von Feldstärkemessungen auch bei Temperatur- und Spannungseinflüssen erhöht werden. Weiters wird in der US 5 406 202 eine Anordnung von mindestens zwei gleichartigen zueinander verdreht angeordneten Hallsonden vorgeschlagen, wobei die Anschlüsse für die Stromversorgung und die Abnahme der Hallspannung zyklisch gegeneinander vertauscht werden und die dabei ermittelten Meßwerte in einer gesonderten Schaltung ausgewertet werden. Auch dadurch soll eine Kompensation der teilweise durch mechanische Spannungen verursachten Offset-Spannung erreicht werden. Weiters ist aus der GB 2 157 887 A ein Schaltkreis bekanntgeworden, bei welchem eine Hallsonde von einem isolierenden Wall, vorzugsweise von zwei konzentrischen isolierenden Wällen umgeben ist, welche die Hallsonde von inneren mechanischen Spannungen, welche beispielsweise durch Einschlüsse im Wafer hervorgerufen werden, freihalten sollen.

Aus der EP 35 103 A1 ist ein Kompensationsverfahren von Piezoeffekten in einem Halbleiterbauelement bekannt geworden, bei dem ein Halbleiterbauelement so ausgestattet wird, daß zur Kompensation von Piezoeffekten mindestens zwei Halbleiterbereiche mit zugehörigen Anschlußkontakten auf einem einkristallinen Halbleiterchip einer integrierten Schaltung in vorbestimmter Lage zueinander angebracht sind und daß das einkristalline Halbleiterchip gewisse vorherbestimmte Kristallrichtungen aufweist.

All diese bekannten Vorschläge zielen darauf ab, die Offset-Spannung von Hallsonden, also einen additiven Fehler der Hallspannung zu kompensieren. Hierfür sind aufwendige Kompensationsschaltungen notwendig, welche den Stromverbrauch der Hallsonde erheblich erhöhen. Derartige Kompensationsschaltungen benötigen darüber hinaus auch zusätzlichen Platz auf dem Chip. Eine Kompensation der durch mechanische Spannungseinflüsse hervorgerufenen Empfindlichkeitsänderung der Hallsonde ist den bekannten Kompensationsverfahren nicht zu entnehmen.

Die vorliegende Erfindung zielt nun darauf ab, ein Verfahren der eingangs genannten Art zu schaffen, welches insbesondere auf die Empfindlichkeitsänderung aufgrund von mechanischen Spannungen Rücksicht nimmt und welches sich darüber hinaus durch einen besonders geringen Stromverbrauch auszeichnet und auch die kontinuierliche Kalibrierung von Hallsonden ermöglicht. Außerdem soll der schaltungstechnische Aufwand sowie die benötigte Chipfläche möglichst gering gehalten werden. Zur Lösung dieser Aufgabe wird erfindungsgemäß so vorgegangen, daß der elektrische Widerstand und/oder eine dem elektrischen Widerstand proportionale Meßgröße der Hallsonde in mindestens zwei voneinander verschiedenen Richtungen ermittelt wird, daß der Mittelwert der ermittelten Widerstände bzw. der dazu proportionalen Meßgrößen berechnet wird und daß der durch die Hallsonde geleitete Strom proportional zum errechneten Mittelwert gewählt wird.

Die Empfindlichkeit S einer Hallsonde bei Vorhandensein eines magnetischen Feldes B ist definiert durch S=I₀ x h(T) x [1 + a_{PH} (σ)], wobei I₀ der durch die Hallsonde geleitete Strom, h(T) die von der Temperatur abhängige Hallkonstante und a_{PH} (σ) die spannungsbedingte relative Änderung der Empfindlichkeit der Hallsonde ist, welche aufgrund des Piezohalleffektes hauptsächlich von den Hauptnormalspannungskomponenten σ11 und σ22 abhängt. Es gilt: apH (σ) = P12 x (σ11 + σ22) + P11 x σ33, wobei σ11, σ22 und σ33 die Normalspannungskomponenten und P12 und P11 die jeweiligen Komponenten des Piezohalltensors bedeuten. Für die Kapselung von Hallsonden in dünnen Kunststoffverpackungen liegt diese relative Änderung der Empfindlichkeit üblicherweise unter 10 %.

Wenn nun der Strom I₀ durch die Hallsonde geleitet wird, kann die Hallspannung VH, welche in einer Richtung quer zur Richtung des Stromes I₀ abfällt, ermittelt werden als VH=S x B + V_{offset}, wobei B die Komponente des magnetischen Feldes normal auf die Oberfläche der Hallsonde und V_{offset} die Offsetspannung bedeutet, welche unter anderem abhängig ist von der Geometrie der Hallsonde und von piezoresistiven Komponenten quer zu I₀. Dadurch, daß nun erfindungsgemäß der durch die Hallsonde geleitete Strom proportional zum Mittelwert der elektrischen Widerstände und/oder von dem elektrischen Widerstand proportionalen Meßgrößen der Hallsonde in mindestens zwei voneinander verschiedenen, vorzugsweise zueinander orthogonalen Richtungen gewählt wird, wird eine äußerst effiziente Kompensation der mechanischen Spannungen erreicht. Die Messungen der elektrischen Widerstände und/oder der dem elektrischen Widerstand proportionalen Meßgrößen in den verschiedenen Richtungen kann an den gleichen Anschlüssen der Hallsonde vorgenommen werden, welche für die Messung der magnetischen Feldstärke herangezogen werden. Alternativ können aber auch die Anschlüsse einer in der unmittelbaren Nähe angebrachten Hilfssonde, welche identisch zu dieser aufgebaut ist, verwendet werden. Die gemessenen Widerstände sind hierbei aufgrund des piezoresistiven Effektes direkt vom mechanischen Spannungszustand der Hallsonde abhängig, sodaß unmittelbar von der Änderung des Mittelwertes der Widerstände auf die Änderung der relativen Empfindlichkeit der Hallsonde geschlossen werden kann.

In bevorzugter Weise wird das erfindungsgemäße Verfahren so durchgeführt, daß zur Ermittlung des mittleren Widerstands nacheinander ein definierter Strom über je zwei einander gegenüberliegende Anschlüsse der Hallsonde oder eine äquivalente Hilfssonde geleitet wird und der Widerstand aus dem Spannungsabfall an diesen Anschlüssen errechnet wird, wobei jedoch auch unmittelbar die Spannungsabfälle, als dem Widerstand proportionale Meßgrößen, für die Mittelwertbildung und anschließende Einstellung des durch die Hallsonde geleiteten Stromes herangezogen werden können. Bei einer Messung des Spannungsabfalles in zwei voneinander verschiedenen, orthogonalen Richtungen ergeben sich somit zwei Spannungen, VAB und VCD, für deren Mittelwert gilt: (VAB + VCD)/2 = Iref x R0(T) x [ 1 + a_{PR} (σ)]. Hierbei bedeuten Iref der durch die Hallsonde geleitete Meßstrom zur Ermittlung des Spannungsabfalles, R0(T) der temperaturabhängige Widerstand der Hallsonde unter spannungsfreien Bedingungen und a_{PR} (σ) jene Komponente der spannungsabhängigen relativen Widerstandsänderung der Hallsonde, welche lediglich von den Normalspannungskomponenten abhängt. Aufgrund der Tatsache, daß für (100) Silizium für einen großen Temperaturbereich gilt: a_{PR} (σ)= -a_{PH} (σ) kann unmittelbar so vorgegangen werden, daß der durch die Hallsonde geleitete Strom gleich dem Produkt aus einer temperaturabhängigen Konstante und dem Mittelwert des Spannungsabfalls gewählt wird. Dadurch, daß nun der durch die Hallsonde geleitete Strom I₀ = G(T) x (VAB + VCD)/2 gewählt wird, können unmittelbar die ermittelten Werte für den Spannungsabfall herangezogen werden, wobei der schaltungstechnische Aufwand für die Bildung des Mittelwertes und die Multiplikation mit einer Konstanten überaus gering gehalten werden kann.

Insgesamt sind somit folgende Möglichkeiten für die Ermittlung der elektrischen Widerstände bzw. der dem elektrischen Widerstand proportionalen Meßgrößen gegeben: An die Hallsonde wird eine Konstantstromquelle gelegt, worauf der Spannungsabfall in der Richtung der Stromeinspeisung gemessen wird. Dies kann entweder in einem Zeitfenster, in welchem die Feldstärkemessung unterbrochen ist, geschehen oder auf einer Hilfssonde. Bei Verwendung einer Hilfssonde bzw. bei Verwendung je einer Hilfssonde für die Widerstandsmessung in einer ersten und in einer zweiten Richtung kann die Feldstärkemessung kontinuierlich erfolgen und die Empfindlichkeit kontinuierlich korrigiert werden. Als Konstantstromquelle kann natürlich auch die für die Erzeugung der Hallspannung verwendete Stromquelle herangezogen werden. In diesem Fall kann an einer einzigen Hallsonde gleichzeitig die Hallspannung und der Spannungsabfall bzw. der Widerstand in einer Richtung gemessen werden. Zur Ermittlung des Widerstandes bzw. des Spannungsabfalls in der zweiten Richtung muß entweder in einem zweiten Zeitfenster die Richtung der Stromeinspeisung geändert werden oder eine zweite Hallsonde herangezogen werden. Schließlich besteht auch die Möglichkeit der Verwendung von Hallsondenpaaren. Ein Hallsondenpaar setzt sich hierbei aus zwei Hallsonden zusammen, bei welchen die Anschlüsse zur Einspeisung des Stromes und zur Abnahme der Hallspannung um 90° zueinander verdreht angeordnet sind. Die direkte Messung des mittleren Widerstandes kann erfindungsgemäß auch ersetzt werden durch die Messung der Hallspannungen wenigstens eines Hallsondenpaares, wobei ein Hallpaar von einer Konstantstromquelle und ein zweites Hallpaar von einer Konstantspannungsquelle gespeist wird und unter Anwendung des Ohm' schen Gesetzes unmittelbar auf den Widerstand der Hallsonden in den zwei zueinander orthogonalen Richtungen geschlossen werden kann. Die Verwendung von Hallsondenpaaren kann wieder durch entsprechende, aufeinanderfolgende Messung an einem einzelnen Hallelement ersetzt werden.

Wie bereits erwähnt kann für die meisten Anwendungsfälle in bevorzugter Art und Weise so vorgegangen werden, daß die Widerstände bzw. die dazu proportionalen Meßgrößen lediglich in zwei normal zueinander liegenden Richtungen ermittelt werden. Das erfindungsgemäße Verfahren kann für Hallsonden der verschiedensten Arten, der verschiedensten Formen und der verschiedensten Abmessungen Verwendung finden. Bei Hallsonden mit unterschiedlichen Kantenlängen wird das erfindungsgemäße Verfahren jedoch bevorzugt so durchgeführt, daß als Mittelwert der Widerstände bzw. der dazu proportionalen Meßgrößen der nach der jeweiligen Kantenlänge der Hallsonde gewichtete Mittelwert gewählt wird. Dadurch wird dem Umstand Rechnung getragen, daß der Widerstand der Hallsonde nicht nur von den mechanischen Spannungen, sondern auch von ihrer Länge in der jeweiligen Meßrichtung abhängt. Wie bereits erwähnt, stellt das erfindungsgemäße Verfahren nur geringe Anforderungen an die Kompensationsschaltungsanordnung, in besonders einfacher Weise wird hierbei so vorgegangen, daß bei aufeinanderfolgender Einzelmessung die Mittelwertbildung über einen Abtast- und Haltekreis realisiert wird. Dabei werden die analogen Widerstands- bzw. Spannungssignale zu bestimmten Zeitpunkten abgetastet und bis zum nächsten Zeitpunkt einer Abtastung gespeichert. In einfacher Weise können die Zeitpunkte der Abtastungen von den selben Taktsignalen gesteuert werden, wie sie für die üblicherweise verwendete Offsetkompensation von Hallsonden herangezogen werden.

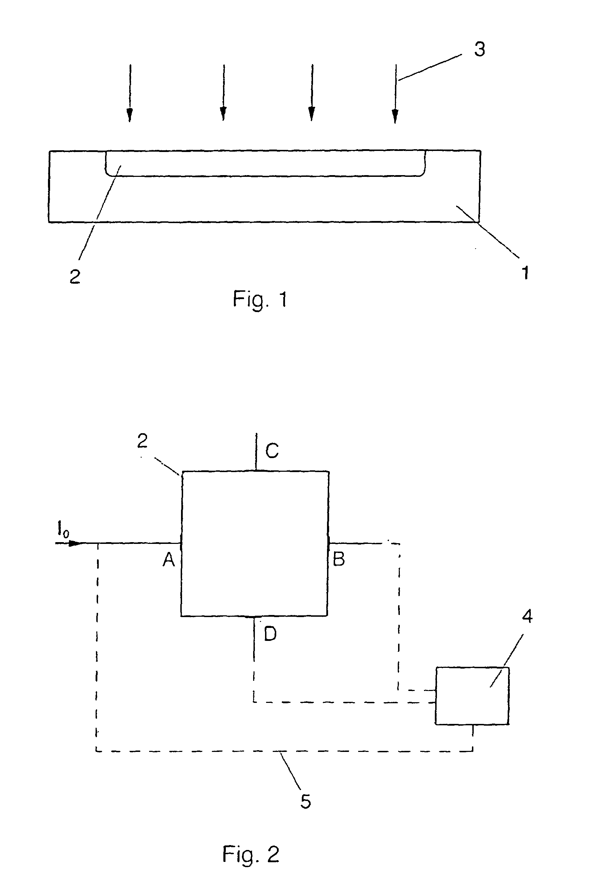

Die Erfindung wird nachfolgend anhand einer in der Zeichnung schematisch dargestellten Hallsonde näher erläutert. In dieser ist Fig. 1 eine Seitenansicht einer Hallsonde und Fig. 2 eine Draufsicht auf die Hallsonde gemäß Fig. 1.

In Fig. 1 ist mit 1 eine Halbleitersubstrat bezeichnet, in welchem eine Hallsonde 2 ausgebildet ist. Auf die Hallsonde 2 wirkt nun ein magnetisches Feld entsprechend der Pfeile 3, dessen Feldstärke gemessen werden soll.

In Fig. 2 sind nun die Anschlüsse A, B, C und D der Hallsonde ersichtlich. Zur Messung der magnetischen Feldstärke wird ein definierter Strom I₀ über die Anschlüsse A und B der Hallsonde durch diese geleitet und die zwischen den Anschlüssen C und D abfallende Spannung gemessen. Die Hallspannung VCD ist hierbei jedoch von äußeren Spannungseinflussen abhängig, welche durch das erfindungsgemäße Verfahren kompensiert werden sollen. Hierfür wird zunächst der Widerstand der Hallsonde in zwei voneinander verschiedenen Richtungen gemessen, wobei zu diesem Zweck ein Referenzstrom über die Anschlüsse A und B durch die Sonde geleitet wird und aus dem Spannungsabfall an den Anschlüssen A und B auf den Widerstand in der Richtung von A zu B der Hallsonde geschlossen werden kann. Auf die gleiche Art und Weise wird der Widerstand der Hallsonde in der Richtung C-D gemessen, wozu wiederum über die Anschlüsse C und D ein Strom durch die Hallsonde geleitet wird und der Spannungsabfall an den Anschlüssen C und D gemessen wird. Anschließend wird der Mittelwert der beiden ermittelten Widerstandswerte in einer Auswerteschaltung 4 errechnet, wobei der während der Magnetfeldmessung durch die Hallsonde geleitete Strom I₀ entsprechend dem errechneten Mittelwert proportional angepaßt wird. Die entsprechende Steuerleitung ist mit 5 bezeichnet.

Insgesamt wird mit dem erfindungsgemäßen Verfahren auf einfache Art und Weise eine wirksame Kompensation von Spannungseinflüssen erreicht, wobei der für die Kompensation zusätzlich notwendige Stromverbrauch äußert gering gehalten werden kann. Der für die Widerstandsmessung notwendige Strom ist hierbei äußerst gering und auch die schaltungstechnisch sehr einfach gestaltete Auswerteschaltung benötigt keine nennenswerten Strommengen. Wie aus dem obigen Beispiel unmittelbar ersichtlich ist, sind für die Kompensationsschaltung keine zusätzlichen Anschlüsse auf der Hallsonde erforderlich und auch der Platzbedarf für die Kompensationsschaltung ist äußerst gering.

## Patentansprüche

1. Verfahren zum Kompensieren von mechanischen Spannungen bei der Messung der magnetischen Feldstärke mittels Hallsonde (2), **dadurch gekennzeichnet, daß** der elektrische Widerstand und/oder eine dem elektrischen Widerstand proportionale Meßgröße wenigstens einer Hallsonde (2) in mindestens zwei voneinander verschiedenen Richtungen ermittelt wird, daß der Mittelwert der ermittelten Widerstände bzw. der dazu proportionalen Meßgrößen berechnet wird und daß der durch die wenigstens eine Hallsonde (2) geleitete Strom proportional zum errechneten Mittelwert gewählt wird.

2. Verfahren nach Anspruch 1, **dadurch gekennzeichnet, daß** zur Ermittlung des Mittelements der Widerstande nacheinander ein definierter Strom über je zwei einander gegenüberliegende Anschlüsse (A,B;C,D) der wenigstens einen Hallsonde (2) oder einer äquivalenten Hilfssonde geleitet wird und der Widerstand aus dem Spannungsabfall an diesen Anschlüssen errechnet wird.

3. Verfahren nach Anspruch 1, **dadurch gekennzeichnet, daß** zur Ermittlung des Mittelements der Widerstände ein Referenzstrom über mindestens ein Hallsondenpaar, bestehend aus zwei hintereinander geschalteten Hallsonden mit zueinander orthogonaler Stromeinspeisung, geleitet wird und der Mittelwert der Widerstände aus den Spannungsabfällen an den Anschlüssen der Hallsondenpaare errechnet wird.

4. Verfahren nach Anspruch 1, 2 oder 3, **dadurch gekennzeichnet, daß** als dem Widerstand proportionale Größen die Spannungsabfälle an den Anschlüssen (A,B;C,D) der wenigstens einen Hallsonde (2) gewählt werden.

5. Verfahren nach einem der Ansprüche 1 bis 4, **dadurch gekennzeichnet, daß** der durch die wenigstens eine Hallsonde (2) geleitete Strom gleich dem Produkt aus einer temperaturabhängigen Konstante und dem Mittelwert des Spannungsabfalls gewählt wird.

6. Verfahren nach einem der Ansprüche 1, 2, 4 oder 5, **dadurch gekennzeichnet, daß** die widerstände bzw. die dazu proportionalen Meßgrößen in zwei normal zueinander liegenden Richtungen ermittelt werden.

7. Verfahren nach einem der Ansprüche 1, 2 oder 4-6, **dadurch gekennzeichnet, daß** zur Ermittlung des Widerstands die Hallspannungen wenigstens eines Hallsondenpaares sowohl bei Strom- als auch bei Spannungseinspeisung herangezogen werden.

8. Verfahren nach einem der Ansprüche 1 bis 7, **dadurch gekennzeichnet, daß** als Mittelwert der Widerstände bzw. der dazu proportionalen Meßgrößen der nach der jeweiligen Kantenlänge der wenigstens einen Hallsonde (2) gewichtete Mittelwert gewählt wird.

9. Verfahren nach einem der Ansprüche 1 bis 8, **dadurch gekennzeichnet, daß** die Mittelwertbildung über einen Abtast- und Haltekreis realisiert wird.

## Claims

1. A method for compensating mechanical tensions during the measurement of magnetic field strengths by the aid of a Hall probe (2), **characterized in that** the electric resistance, and/or a measuring quantity proportional to the electric resistance, of at least one Hall probe (2) is determined in at least two different directions, that the mean value of the determined resistances, or measuring quantities proportional thereto, is calculated, and that the current conducted through the at least one Hall probe (2) is chosen to be proportional to the calculated mean value.

2. A method according to claim 1, **characterized in that**, for the determination of the mean value of the resistances, a defined current is each consecutively conducted through two oppositely arranged connections (A,B;C,D) of the at least one Hall probe (2), or an equivalent auxiliary probe, and that the resistance is calculated from the voltage drop occurring across these connections.

3. A method according to claim 1, **characterized in that**, for the determination of the mean value of the resistances, a reference current is conducted through at least one Hall probe pair comprised of two consecutively arranged Hall probes having orthogonal current infeeds, and that the mean value of the resistances is calculated from the voltage drops occurring across the connections of the Hall probe pairs.

4. A method according to claim 1, 2 or 3, **characterized in that** the voltage drops across the connections (A,B;C,D) of the at least one Hall probe (2) are selected as quantities proportional to the resistance.

5. A method according to any one of claims 1 to 4, **characterized in that** the current conducted through the at least one Hall probe (2) is chosen to be equal to the product of a temperature-dependent constant and the mean value of the voltage drop.

6. A method according to any one of claims 1, 2, 4 or 5, **characterized in that** the resistances, or measuring quantities proportional thereto, are determined in two directions normal to each other.

7. A method according to any one of claims 1, 2 or 4 to 6, **characterized in that** the Hall voltages of at least one pair of Hall probes at both current and voltage infeeds are used for the determination of said resistance.

8. A method according to any one of claims 1 to 7, **characterized in that** the mean value weighted according to the respective edge length of the at least one Hall probe (2) is chosen as said mean value of the resistances, or measuring quantities proportional thereto.

9. A method according to any one of claims 1 to 8, **characterized in that** the formation of said mean value is realized via a sample-and-hold circuit.

## Revendications

1. Procédé pour la compensation de contraintes mécaniques lors de la mesure de l'intensité de champ magnétique au moyen d'une sonde à effet Hall (2), **caractérisé en ce que** la résistance électrique et/ou une grandeur de mesure proportionnelle à la résistance électrique d'au moins une sonde à effet Hall (2) est déterminée dans au moins deux directions différentes, **en ce que** la moyenne des résistances déterminées ou des grandeurs de mesure proportionnelles à celles-ci est calculée et **en ce que** le courant passant par la sonde à effet Hall (2) au nombre d'une au moins est sélectionné pour être proportionnel à la moyenne calculée.

2. Procédé selon la revendication 1, **caractérisé en ce qu'**afin de déterminer la moyenne des résistances, un courant défini est acheminé successivement par deux connexions opposées l'une à l'autre (A, B ; C, D) de la sonde à effet Hall (2) au nombre d'une au moins ou d'une sonde auxiliaire équivalente et la résistance est calculée à partir de la baisse de tension au niveau de ces connexions.

3. Procédé selon la revendication 1, **caractérisé en ce qu'**afin de déterminer la moyenne des résistances, un courant de référence est acheminé par au moins une paire de sondes à effet Hall composée de deux sondes à effet Hall montées à la suite de l'autre avec des alimentations électriques perpendiculaires l'une à l'autre, et la moyenne des résistances est calculée à partir des baisses de tension au niveau des connexions des paires de sondes à effet Hall.

4. Procédé selon la revendication 1, 2 ou 3, **caractérisé en ce que** la grandeur proportionnelle à la résistance choisie est la baisse de tension aux connexions (A,B ; C,D) de la sonde à effet Hall (2) au nombre d'une au moins.

5. Procédé selon l'une des revendications 1 à 4, **caractérisé en ce que** le courant passant par la sonde à effet Hall (2) au nombre d'une au moins est choisi égal au produit d'une constante dépendante de la température par la moyenne de la baisse de tension.

6. Procédé selon l'une des revendications 1, 2, 4 ou 5, **caractérisé en ce que** les résistances ou les grandeurs de mesure proportionnelles à celles-ci sont déterminées dans deux directions perpendiculaires l'une à l'autre.

7. Procédé selon l'une des revendications 1, 2 ou 4 à 6, **caractérisé en ce qu'**afin de déterminer la résistance, les tensions de Hall d'au moins une paire de sondes à effet Hall sont utilisées aussi bien pour l'alimentation en intensité que pour l'alimentation en tension.

8. Procédé selon l'une des revendications 1 à 7, **caractérisé en ce que** la moyenne des résistances ou des grandeurs de mesure proportionnelles à celles-ci est la moyenne pondérée par la longueur de chacune des tranches d'au moins une sonde à effet Hall (2).

9. Procédé selon l'une des revendications 1 à 8, **caractérisé en ce que** le calcul de la moyenne est réalisé par un circuit d'interrogation et de maintient.
